(19) Europäisches Patentamt
European Patent Office
Office européen des brevets

(11) Publication number : 0 535 828 A1

# (12) EUROPEAN PATENT APPLICATION

(21) Application number : 92308452.9

(22) Date of filing : 17.09.92

(51) Int. Cl.$^5$ : **G03C 9/08**, G03F 7/031, G03F 7/09

(30) Priority : 30.09.91 JP 251512/91

(43) Date of publication of application : 07.04.93 Bulletin 93/14

(84) Designated Contracting States : AT BE CH DE DK ES FR GB IT LI LU NL SE

(71) Applicant : IMPERIAL CHEMICAL INDUSTRIES PLC
Imperial Chemical House, Millbank
London SW1P 3JF (GB)

(72) Inventor : Doba, Takahisa
33-24 Umezono-2-chome
Postal code 305, Tsukuba-shi, Ibaraki (JP)

(74) Representative : Stephenson, Kenneth et al
ICI Group Patents Services Dept. PO Box 6
Shire Park Bessemer Road
Welwyn Garden City, Herts, AL7 1HD (GB)

## (54) Photostereolithographic process.

(57) A method of generating three-dimensional objects comprising applying light of wavelength 450-550 nm by a stereolithographic technique to a photopolymerisable resin composition comprising :

(a) a compound having at least one polymerisable unsaturated bond per molecule and a free radical photoinitiator, and/or

(b) a compound capable of cationic polymerisation and a cationic photoinitiator,

said photopolymerisable resin composition also containing a compound of which the wavelength of maximum absorption is in the range 400-600 nm.

EP 0 535 828 A1

This invention relates to a method of forming a three-dimensional moulding from a photopolymerisable resin having high sensitivity to active radiation. In particular, it relates to a photostereolithographic technique using a resin composition from which mouldings having high dimensional accuracy can be formed because of the improved cure depth of the liquid photocurable resin composition when subjected to selective exposure using a laser beam optical system.

A stereolithographic technique is known whereby an amount of a liquid photocurable resin composition corresponding to one layer or slice of a three-dimensional article to be formed is supplied to a container located on a movable platform and irradiated with a programmed laser beam so as to form a solidifed layer of cured resin. The platform is then lowered, further unpolymerised resin composition is supplied on top of the cured layer and the process is repeated until the complete object is constructed, slice by slice, from the bottom to the top. The formed article may then be subjected to a post-cure to minimise residual unpolymerised material. The technique allows the rapid construction of solid, complex shaped, three-dimensional objects without the need for expensive tooling equipment or moulds, especially objects containing voids or having irregular shapes.

In the aforementioned technique, it is known to use a UV-curable resin composition and a helium-cadmium laser as a source of ultraviolet radiation. For reasons of safety, more economical equipment and improved power output, it is also known to use visible light argon-ion lasers but, in visible light cured systems, there has been an accuracy problem related to the cure depth. In this connection, "cure depth" means the depth (thickness) of cure obtained when a photocurable resin composition is irradiated with light.

In said photomoulding technique, the production of threedimensional shapes with the desired accuracy has been a problem because of the need to control the cure depth so as to be of the same order as the step width, that is to say the thickness of a single layer of the layers which make up the three-dimensional shape. Since the step width is generally about 100 microns (μm), the cure depth should not exceed 500 microns (0.5 mm) and should preferably be 100 microns or less but, generally speaking, a photoradical polymerisation initiator or a photocationic polymerisation initiator for the visible light region has a small extinction coefficient and limited solubility in a resin compared with corresponding initiators for ultraviolet radiation resulting in a cure depth of 1.0 mm or more with consequent severe deterioration in the dimensional accuracy of the moulding.

It is an object of the invention to solve the above mentioned problem by providing a three-dimensionally mouldable photocurable resin composition having a cure depth of 0.5 mm or less when exposed to visible light.

It has now been found that the cure depth of a photocurable resin composition can be controlled by dispersing or dissolving therein a compound having maximum absorption in the wavelength range 400-600 nm, the cure of the resin composition being controllable to a depth of 0.5 mm or less when irradiated by light having a wavelength in the range 450-550 nm.

Accordingly, the present invention provides a method of generating three-dimensional objects comprising applying light of wavelength 450-550 nm by a stereolithographic technique to a photopolymerisable resin composition comprising:

(a) a compound having at least one polymerisable unsaturated bond per molecule and a free radical photoinitiator, and/or

(b) a compound capable of cationic polymerisation and a cationic photoinitiator,

said photopolymerisable resin composition also containing a compound of which the wavelength of maximum absorption is in the range 400-600 nm.

There is no particular restriction on the type of compound (hereinafter referred to as a dye) having a wavelength of maximum absorption ($\lambda$ max) in the range 400-600 nm so long as it is sufficiently soluble in thephotocurable resin composition and it may be a dye of, for example, the xanthene, anthraquinone or azo series.

Suitable examples of dyes include xanthene dyes such as 2′,7′-dichlorofluorescein, Chromazurol S, Erythrosine B, Methyl Eosine and merbromin, anthraquinone dyes such as Disperse Orange 11, New Clear Fast Red and 1-methylaminoanthraquinone, azo dyes such as Disperse Orange 1, Disperse Orange 3, Disperse Orange 13, Disperse Orange 25, Disperse Red 1, Disperse Red 13, Disperse Yellow 3 and the like.

Dyes capable of acting as photosensitisers are preferred because of their advantageous effect on the photopolymerisation.

As examples of compounds having at least one polymerisable unsaturated bond per molecule, there may be mentioned the following classes of ethylenically unsaturated compounds:

(1) Unsaturated polyesters such as may be obtained by direct esterification of an unsaturated polycarboxylic acid or anhydride thereof, a saturated polycarboxylic acid or anhydride thereof and a polyol.

Suitable unsaturated acids or anhydrides include maleic anhydride, fumaric acid, citraconic acid and itaconic acid.

Suitable saturated acids or anhydrides include phthalic anhydride, isophthalic acid, terephthalic acid, tetrahydrophthalic anhydride, hexahydrophthalic anhydride, succinic acid, adipic acid, azelaic acid, sebacic acid, tetrachlorophthalic anhydride and endomethylene tetrahydrophthalic anhydride.

Suitable polyols include ethylene glycol, propylene glycol, 1,4-butanediol, 1,3-butanediol, 2,3-butanediol, diethylene glycol, dipropylene glycol, triethylene glycol, 1,5-pentanediol, 1,6-hexanediol, neopentyl glycol, hydrogenated bisphenol A, glycerol, trimethylolpropane monoallyl ether and glycerol monoallyl ether.

(2) Polyester acrylates such as may be obtained by direct esterification of a polyol, a polycarboxylic acid or anhydride thereof and acrylic acid in the presence of a catalyst.

Suitable polyols include ethylene glycol, propylene glycol, diethylene glycol, dipropylene glycol, 1,4-butanediol, 1,3-butanediol, 1,6-hexanediol, neopentyl glycol, hydrogenated bisphenol A, glycerol, trimethylolpropane, pentaerythritol and dipentaerythritol.

Suitable polybasic acids or anhydrides include phthalic anhydride, isophthalic acid, terephthalic acid, tetrahydrophthalic anhydride, hexahydrophthalic anhydride, succinic acid, adipic acid, azelaic acid and sebacic acid.

(3) Urethane acrylates such as may be obtained by reaction of an unsaturated alcohol such as 2-hydroxyethyl acrylate, a polyester or polyether polyol and a diisocyanate.

Suitable polyester polyols include esterification products of the polyols and polybasic acids mentioned in (2) above as well as polycaprolactone polyols.

Suitable polyether polyols include polyethylene glycol, polypropylene glycol and polytetramethylene glycol.

Suitable diisocyanates include toluene diisocyanate, 4,4′-diphenylmethane diisocyanate, hexamethylene diisocyanate and isophorone diisocyanate.

(4) Epoxy acrylates such as reaction products of bisphenol diglycidyl ethers, diglycidyl esters or alicyclic epoxy compounds having at least two epoxy groups per molecule with acrylic acid.

Suitable bisphenol diglycidyl ethers include compounds of the formula:

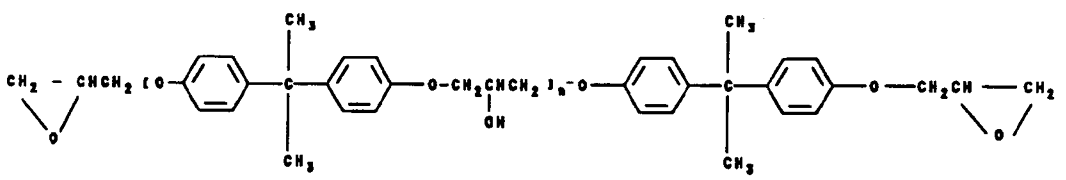

(1)

where n is an integer from 0 to 12.

Examples include the Shell products Epikote 827, Epikote 828 and Epikote 1001.

Suitable diglycidyl esters include compounds of the formula:

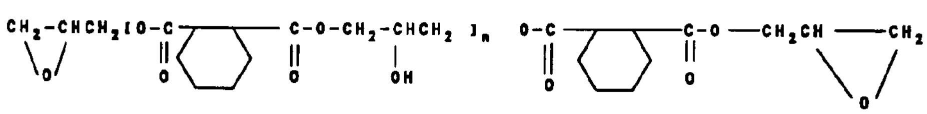

(2)

where n is as defined above.

Examples include the Ciba-Geigy products Araldite CY-175 and Araldite CY-176.

Suitable alicyclic epoxy compounds include 3,4-epoxycyclohexylmethyl 3,4-epoxycyclohexane carboxylate having the formula:

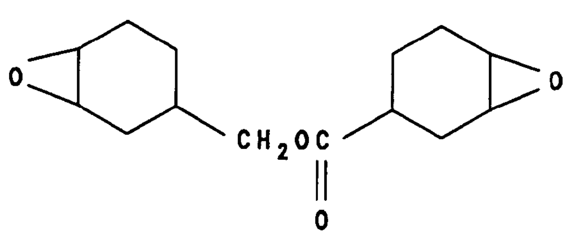

(3)

(5) Unsaturated acrylate series compounds such as may be obtained by reaction of an unsaturated spiroacetal, an unsaturated alcohol such as 2-hydroxyethyl acrylate and a saturated polyol or polyester polyol with or without modification. These unsaturated compounds comprise oligomers or polymers having at

least one, preferably two or more unsaturated groups per molecule as the main components.

As examples of free radical generating photoinitiators to be included in the photopolymerisable resin composition, there may be mentioned α-ketocarbonyl compounds, thioxanthone compounds, anthraquinone compounds, acyl phosphine oxide compounds, onium salts and the like.

Suitable α-ketocarbonyl compounds include α-diketones, α-ketoaldehydes, α-ketocarboxylic acids, α-ketocarboxylates and the like. Examples of α-diketones include diacetyl, 2,3-pentanedione, 2,3-hexanedione, benzil, 4,4′-dimethoxybenzil, 4,4′-diethoxybenzil, 4,4′-dihydroxybenzil, 4,4′-dichlorobenzil, 4-nitrobenzil, α-naphthil, β-naphthil, camphorquinone, 1,2-cyclohexanedione and the like. Examples of α-ketoaldehydes include methylglyoxal, phenylglyoxal and the like. Examples of α-ketocarboxylic acids and α-ketocarboxylates include pyruvic acid, benzoylformic acid, phenylpyruvic acid, methyl pyruvate, ethyl benzoylformate, methyl phenylpyruvate, butyl phenylpyrurate and the like. The preferred α-ketocarbonyl compounds are α-diketones for stability reasons, the preferred α-diketones being diacetyl, benzil and camphorquinone.

Suitable xanthone or anthraquinone compounds may be represented by the general formula:

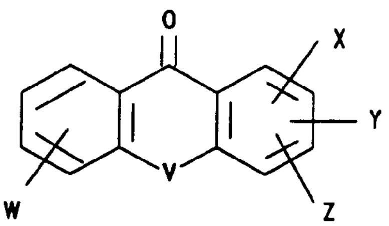

(4)

wherein V represents S or CO and each of X, Y, Z and W, independently, represents hydrogen, $C_1$-$C_{12}$-alkyl which may optionally be substituted by hydroxy and/or halogen, $C_{1-8}$-alkoxy, benzyloxy, allyloxy, $C_1$-$C_{18}$-acyloxy which may optionally contain an unsaturated double bond, $C_1$-$C_8$-alkoxycarbonyl which may optionally be substituted by hydroxy and/or halogen, glycidyloxycarbonyl, allyloxycarbonyl, vinyloxycarbonyl, cyclohexyl, phenyl or phenoxy.

Suitable acylphosphine oxide compounds may be represented by the general formula:

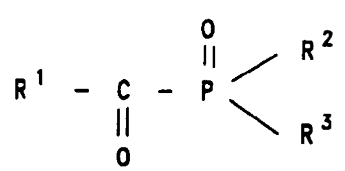

(5)

wherein $R^1$ represents optionally substituted phenyl, for example chlorophenyl, methylphenyl and the like, and each of $R^2$ and $R^3$, independently, represents $C_1$-$C_{12}$-alkyl, $C_1$-$C_{12}$-alkoxy or optionally substituted phenyl, for example chlorophenyl, methylphenyl and the like.

Suitable onium salts include the double salts represented by the general formula:

$$[R_aZ^1]^{+c}\,[MX^1{}_b]^{-c}$$

wherein $Z^1$ represents S, Se, Te, P, As, Sb, Bi, O, hologen (especially I, Br or Cl) or N=N, R represents one or more organic groups which may be the same or different, a represents the sum of the bonds provided by the terminal carbon atoms of said organic groups, c represents the sum of the valences of R and $Z^1$ (but is the difference if the valence of $Z^1$ is negative), M represents a metal or metalloid which is the central atom of a halogenated complex and is such as B, P, As, Sb, Fe, Sn, Bi, Al, Ca, In, Ti, Zn, Sc, V, Cr, Mn, Co and the like, $X^1$ represents a hologen otom, b represents the number of hologen atoms in the halogenated complex ion and c represents the net charge of the halogenated complex ion.

Specific examples of the onion $MX^1{}_b$ in the above formula include tetrafluoroborate $(BF_4)^-$, hexafluorophosphate $(PF_6)^-$, hexafluoroantimonate $(SbF_6)^-$, hexafluoroarsenate $(AsF_6)^-$, hexachloroantimonate $(AsC1_6)^-$ and the like.

Additionally, onions represented by the general formula $MX^1{}_b(OH)^-$ may also be present. Examples of other useful onions include perchlorate $(C1O_4)^-$, trifluoromethylsulphonate $(CF_3SO_3)^-$, fluorosulphonate $(FSO_3)^-$ toluenesulphonate, trinitrobenzenesulphonate and the like.

Of these onium salts, it is particularly effective to use aromotic onium salts as the cationic photoinitiator, and the halonium salt described in Japanese Patent Disclosures 50-151996, 50-158680 etc., the Group VIA

aromatic onium salt described in Japanese Patent Disclosures 50-151997, 52-80899, 56-55420 and 55-125105, the Group VA onium salt described in Japanese Patent Disclosure 50-168698 etc., the oxosulphonium salt described in Japanese Patent Disclosures 56-8428, 56-149402, 57-192429 etc., the thiapyrilium salt described in Japanese Patent Disclosure 49-17040 etc., are especially preferred. Iron-arene complex and aluminium complexes with silicon compounds may also be mentioned as initiators.

The efficiency of these free radical photoinitiators may be improved by combining them with amines.

Amines which may be incorporated in the photocurable resin composition include aliphatic, alicyclic and aromatic amines and they may be primary secondary or tertiary amines. It is preferred to use aromatic amines, especially the tertiary amines.

Examples of specific amines include aliphatic amines such as triethylamine, tripropylamime, tributylamine, tripentylamine, trihexylamine, trioctylamine, diethylamine, dipropylamine, dibutylamine, dihexylamine, butylamine, hexylamine, octylamine, decylamine, dodecylamine and the like, alicyclic amines such as tricyclohexylamine, dicyclohexylamine, cyclohexylamine and the like and aromatic amines such as aniline, toluidine, xylidine, phenylene diamine, N,N-dimethylaniline, N,N-diethylaniline, N,N-di(β-hydroxyethyl) aniline, N,N-dimethyltoluidine, N,N-diethyltoluidine, N,N-dimethylanisidine, N,N-diethylanisidine, N,N-dimethyl-t-butylaniline, N,N-diethyl-t-butylaniline, N,N-dimethyl-p-chloroaniline, diphenylamine, N,N-bis(β-hydroxyethyl)-p-toluidine, 4-dimethylaminobenzoic acid, methyl 4-dimethylaminobenzoate, 4-dimethylaminobenzaldehyde, 4-diethylaminobenzoic acid, methyl 4-diethylaminobenzoate, N,N-dimethyl-p-cyanoaniline, N,N-dimethyl-p-bromoaniline and the like.

Preferred amines include aromatic tertiary amines such as N,N-di(β-hydroxyethyl)aniline, N,N-dimethylaniline, N,N-bis(β-hydroxyethyl)-p-toluidine, N,N-dimethyl-p-toluidine, N,N-dimethylaminobenzoic acid, N,N-diethylaminobenzoic acid and the like.

Furthermore, there may be used a free radical photoinitiator system comprising two or more compounds selected from a halogenated compound as represented by 2,4,6-tris(trichloromethyl)-s-triazine and its derivatives, 1,4,5,6,7,7-hexachloro-5-norbornene-2,3-dicarboxylic anhydride and the like, a peroxide as represented by 1,3-di(t-butyldioxycarbonyl)benzene, 3,3′,4,4′-tetrakis(t-butyldioxycarbonyl)benzophenone and the like, a photo-oxide as represented by benzophenone, xanthone and the like, an onium salt as represented by iodonium, sulphonium, iron-arene complex, a dye as represented by dyes of the cyanine series, N-phenylglycine, 3,3′-carbonylbis (7-diethylaminocoumarin) and the like and other dyes as represented by dyes of the xanthene series.

The compound capable of cationic polymerisation which may be used in accordance with the invention is a compound which exhibits a polymerisation or crosslinking reaction when irradiated with an energy beam in the presence of a cationic photoinitiator and may comprise, for example, one or more of an epoxy compound, a cyclic ether, a lactone, a cyclic acetal, a cyclic thioether, a spiro-orthoester, a vinyl compound and the like. Of the compounds capable of cationic polymerisation, known aromatic, alicyclic or aliphatic epoxy compounds having at least two epoxy groups per molecule are preferred.

As preferred examples of epoxy compounds there may be mentioned polyglycidyl ethers of polyphenols having at least one aromatic ring or of the corresponding alkylene oxide adducts. More specific examples include novolak epoxy compounds and glycidyl ethers obtained by the reaction of bisphenol A, bisphenol F or their alkylene oxide adducts with epichlorohydrin.

As preferred examples of alicyclic epoxy compounds, there may be mentioned polyglycidyl ethers of polyols having at least one alicyclic ring or cyclohexene oxide or cyclopentene oxide containing compounds obtained by epoxidation of a cyclohexene or cyclopentene ring containing compound using a suitable oxidant such as hydrogen peroxide, a peracid and the like. As specific examples of alicyclic epoxy compounds, there may be mentioned the diglycidyl ether of hydrogenated bisphenol A, 3,4-epoxycyclohexylmethyl 3,4-epoxycyclohexane carboxylate, 2-(3,4-epoxycyclohexyl-5,5-spiro-3,4-epoxy)cyclohexane-m-dioxane, bis(3,4-epoxycyclohexylmethyl) adipate, vinylcyclohexene dioxide, 4-vinylepoxycyclohexane, bis(3,4-epoxy-6-methylcyclohexylmethyl) adipate, 3,4-epoxy-6-methylcyclohexane carboxylate, methylenebis(3,4-epoxycyclohexane), dicyclopentadiene diepoxide, di(3,4-epoxycyclohexylmethyl) ether of ethylene glycol, ethylenebis(3,4-epoxycyclohexane carboxylate), dioctyl epoxyhexahydrophthalate, di-2-ethylhexyl epoxyhexahydrophthalate and the like.

As preferred examples of aliphatic epoxy compounds, there may be mentioned polyglycidyl ethers of aliphatic polyols or their alkylene oxide adducts, polyglycidyl esters of aliphatic long chain polybasic acids, homopolymers or copolymers of glycidyl acrylate or methacrylate and the like. As specific examples, there may be mentioned the diglycidyl ether of 1,4-butanediol, the diglycidyl ether of 1,6-hexanediol, the triglycidyl ether of glycerol, the triglycidyl ether of trimethylolpropane, the tetraglycidyl ether of sorbitol, the hexaglycidyl ether of dipentaerythritol, the diglycidyl ether of polyethylene glycol, the diglycidyl ether of polypropylene glycol, diglycidyl ethers of polyether polyols obtained by addition of at least one alkylene oxide to an aliphatic polyol

such as ethylene glycol, propylene glycol, glycerol, and the like, and diglycidyl esters of aliphatic long chain dibasic acids. Furthermore, monoglycidyl ethers of aliphatic higher alcohols, monoglycidyl ethers of phenol, cresol, butylphenol or polyether alcohols obtained by addition of alkylene oxide to these, monoglycidyl esters of higher fatty acids, epoxidised soyabean oil, butyl epoxystearate, octyl epoxystearate, epoxidised linseed oil, epoxidised polybutadiene and the like can also be used.

As examples of cationic polymerisable compounds other than epoxy compounds, there may be mentioned oxetane compounds such as trimethylene oxide, 3,3-dimethyloxacyclobutane, 3,3-bis(chloromethyl)oxacyclobutane and the like, oxolane compounds such as tetrahydrofuran and 2,3-dimethyltetrahydrofuran, cyclic acetal compounds such as trioxane, 1,3-dioxolane and 1,3,6-trioxacyclo-octane, lactones such as β-propiolactone and E-caprolactone, thiirane compounds such as ethylene sulphide and thioepichlorohydrin, thietane compounds such as 1,3-propylene sulphide and 3,3-dimethylthietane, vinyl ethers such as ethylene glycol divinyl ether, alkyl vinyl ethers, 3,4-dihydrofuran-2-methyl 3,4-dihydropyran-2-carboxylate and triethylene glycol divinyl ether, spiro-orthoester compounds obtained by reaction of an epoxy compound with a lactone and ethylenically unsaturated compounds such as vinylcyclohexane, isobutylene, polybutadiene and derivatives thereof. The cationic polymerisable compound may be used singly or in mixtures of two or more such compounds to provide the desired properties.

The most preferred of the cationic polymerisable compounds are the aliphatic epoxy compounds having at least two epoxy groups per molecule because of their reactivity to cationic polymerisation, low viscosity, transparency to visible light, thick curing and low volume shrinkage.

The cationic photoinitiator which may be used in accordance with the invention is a compound capable of releasing a substance to initiate cationic polymerisation when irradiated with an energy beam. Preferred cationic photoinitiators include double salts which are onium salts capable of releasing a Lewis acid when irradiated by an energy beamo These have been described above in the discussion of free radical photoinitiators.

The amount of dye to be incorporated in the photopolymerisable resin composition should be sufficient to ensure that the cure depth of the composition is 0.5 mm or less when exposed to light of wavelength 450-550 nm and is generally not less than 0.01% by weight and not more than 10%, preferably not more than 1%, by weight. Amounts of dye exceeding 10% by weight can have an adverse effect on the properties of the photopolymerisable resin composition whilst amounts less than 0.01% by weight do not generally provide the desired improvement in the accuracy of the cure depth.

The dye may be used singly or as a mixture of two or more dyes and may also be used jointly with a reducing agent having absorption in the visible light region, for example 3,3′-carbonylbis (7-diethylaminocoumarin).

The amount of the free radical and/or cationic photoinitiator to be incorporated in the photopolymerisable resin composition may vary from 1/5 to 1/500 of the amount of polymerisable unsaturated compound and/or cationic polymerisable compound on a weight basis but is preferably in the range from 1/10 to 1/100. If the amount of the free radical and/or cationic photoinitiator is below the lower limit of the above mentioned range, the photosensitisation rate is reduced and the time taken for the composition to cure (to solidify) is extended. On the other hand, if it exceeds the upper limit of the above mentioned range, there is a deterioration in the strength of the film formed from said composition and in its solvent resistance and it becomes of no practical value.

The photopolymerizable resin composition contains the aforementioned free radical and/or cationic photoinitiator but may also contain other polymerisation initiators or additives for the photopolymerisation. Examples of conventional additives include solvents, polymeric binders, thermal polymerisation inhibitors, plasticisers and organic or inorganic fillers which may be used singly or jointly.

Examples of solvents which may be incorporated in the photopolymerisable resin composition include ketones such as methyl ethyl ketone, acetone, cyclohexanone and the like, esters such as ethyl acetate, butyl acetate and the like, aromatic solvents such as toluene, xylene and the like, "Cellosolve" solvents such as methyl "Cellosolve", ethyl "Cellosolve", butyl "Cellosolve" and the like, alcohols such as methanol, ethanol, propanol and the like and ethers such as tetrahydrofuran, dioxane and the like.

Polymeric binders may be used to improve compatibility, film-forming, developing, adhesion, etc., and may be selected to satisfy the particular application. For example, in order to improve development when using an aqueous solvent, copolymers of acrylic (or methacrylic) acid and an alkyl acrylate (or methacrylate), itaconic acid copolymers, partially esterified maleic acid copolymers, modified cellulose acetate having a carboxyl-substituted side chain, poly(ethylene oxide), poly(vinylpyrrolidone) and the like are useful.

In order to improve film strength and adhesion, polyamides and polyethers derived from the diglycidyl ether of bisphenol A are useful.

Thermal polymerisation inhibitors which may be used include hydroquinone, p-methoxyphenol, pyrogallol, catechol, 2,6-di-t-butyl-p-cresol, β-naphthol and the like.

Useful plasticisers include dialkyl esters of phthalic acid such as dioctyl phthalate, didodecyl phthalate,

dibutyl phthalate and the like and dialkyl esters of aliphatic dibasic acids such as dioctyl adipate, dibutyl adipate, dibutyl sebacate and the like.

Examples of organic fillers include polymethacrylate and nylon beads and fibre reinforcement comprising fibres of carbon, aramids, nylon and the like.

Examples of inorganic fillers include calcium carbonate, calcium silicate, titanium oxide, antimony trioxide, aluminium hydroxide, talc, clay, alumina, calcium hydroxide, magnesium carbonate and the like and fibres derived therefrom.

Suitable light sources for the curing operation include lasers such as argon lasers, helium-cadmium lasers, krypton lasers and the like and also conventional light sources for generating ultraviolet radiation or visible light such as extra high pressure mercury lamps, high pressure mercury lamps, medium pressure mercury lamps, metal halide lamps, xenon lamps, tungsten lamps and the like.

The invention is illustrated but not limited by the following Examples in which all parts are by weight.

## Example 1

A mixture of the diacrylate of ethylene oxide modified bisphenol A (hereinafter described as Monomer I) and isobornyl acrylate (hereinafter described as Monomer II) was used as the ethylenically unsaturated compound. The free radical photoinitiator was camphorquinone (hereinafter described as Initiator I) and the sensitiser was N,N-diethylaminoethyl methacrylate (hereinafter described as Sensitiser I). The dye used was 2',7'-dichlorofluorescein having the formula:

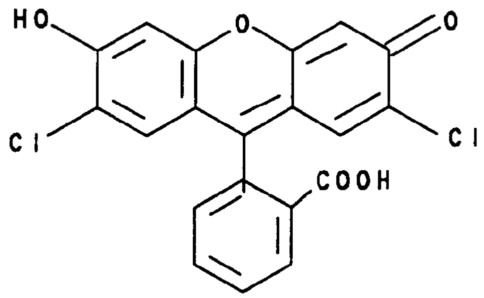

(6)

50 parts of Monomer I, 47 parts of Monomer II, 1 part of Initiator I, 1 part of Sensitiser I and 1 part of the dye were thoroughly mixed.

The maximum absorption wavelength ($\lambda$ max) of the photopolymerisable resin composition was determined and the figure (509 nm) shown in Table 2 was obtained. Then, the resin composition was filled into a moulding space hollowed out of the centre of 10 mm thick silicone rubber and was covered by black chloroprene rubber (1 mm thick) having a hole (approx 1 $mm^2$) at its centre. The amount of resin composition was adjusted so that its upper level corresponded with the upper level of the chloroprene rubber.

A halogen lamp was then installed at a distance of approximately 5 mm from the aforementioned surface of the hole in the chloroprene rubber and radiation was applied for 1 minute.

After irradiation, the chloroprene rubber was peeled off and the thickness of the photocurable resin adhering to the central hole of said chloroprene rubber because of polymerisation was measured, the cured film thickness being described hereinafter as the cure depth.

## Example 2

As for Example 1 except that the dye of Formula 6 was replaced by the dye of the formula:

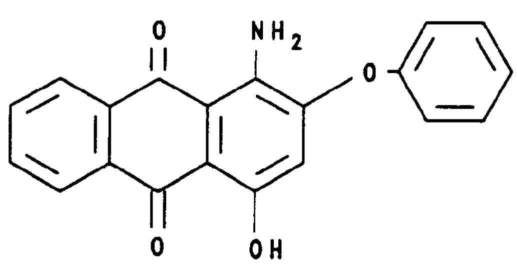

(7)

This dye is DISPERSOL Red B-2B available from Imperial Chemical Industries PLC.

**Example 3**

As for Example 1 except that the dye of Formula 6 was replaced by the dye of the formula:

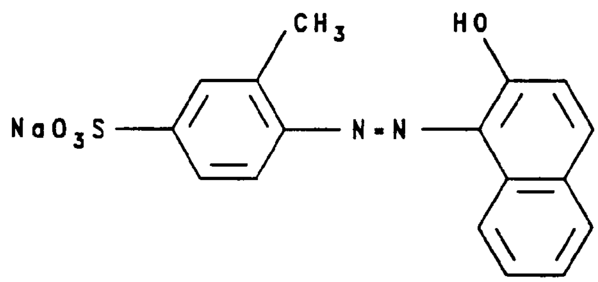

(8)

This dye is C.I. Acid Orange 8.

**Example 4**

As for Example 1 except that the dye of Formula 6 was replaced by the dye of the formula:

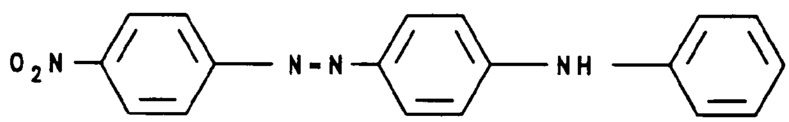

(9)

This dye is C.I. Disperse Orange 1,

In Examples 2-4, the components were incorporated in the amounts shown in Table 1. As in Example 1, the maximum absorption wavelengths (λ max) were measured and are given in Table 2. The moulding and irradiation procedures were as described in Example 1, the results being given in Table 2.

**Example 5**

97 parts of a compound capable of cationic polymerisation, 3,4-epoxycyclohexylmethyl 3,4-epoxycyclohexane carboxylate (hereinafter described as Monomer III), 1 part of a cationic photoinitiator, ($\eta^5$-2,4-cyclopentadiene-1-yl) [(1,2,3,4,5,6-η)-(1-methylethyl)-benzene]-iron(+1)-hexafluorophosphate (Ciba-Geigy product, CG 24-61) (hereinafter described as Initiator II), and 1 part of the dye of Fomula 6 were thoroughly mixed.

The maximum absorption wavelength (λ max) and the cure depth were determined as described in Example 1, the results being shown in Table 2.

**Examples 6-8**

The procedure described in Example 5 was repeated except that the dye of Formula 6 was replaced, respectively, by the dyes of Formula 7, Formula 8 and Formula 9. The compositions are given in Table 1 and the results, obtained as in Example 1, in Table 2.

**Example 9**

A mixture of photoradically curable monomer and photocationically curable monomer together with the appropriate initiators and sensitiser were used. Thus, as shown in Table 1, 24 parts of Monomer I, 24 parts of Monomer II and 48 parts of Monomer III were thoroughly mixed with 1 part of Initiator I, 1 part of Initiator II, 1 part of Sensitiser I and 1 part of the dye of Formula 6.

The maximum absorption wavelength (λ max) and the cure depth were determined as described in Example 1, the results being shown in Table 2.

## Comparative Examples 1-3

In the Comparative Examples, no dye was added, Monomer 1, Monomer II, Initiator I and Sensitiser I being used in Comparative Example 1, Monomer III and Initiator II in Comparative Example 2 and Monomers I, II and III, Initiators I and II and Sensitiser I in Comparative Example 3. The preparation of the photocurable resin compositions and the determination of the maximum absorption wavelength (λ max) and cure depth were carried out as described in Example 1, the results being shown in Table 2.

It is clear from Table 2 that in Examples 1-9 using dyes having maximum absorption in the wavelength range of the irradiated light, the cure depth was less than 0.5 mm and could be controlled as desired. On the other hand, in Comparative Examples 1-3, the maximum absorption was not in the range 400-600 nm, the main wavelength of the light radiating from the halogen lamp, because no dye was used and the cure depth became 10 mm or more and could not be controlled to the desired low level.

Thus, the invention as hereinbefore described, provides a photopolymerisable resin composition which cures rapidly when exposed to light radiation having a wavelength in the range 450-550 nm to give a cure depth of 0.5 mm or less, said composition being of practical value in photostereolithography applications because of its excellent controllability.

**TABLE 1**

**Composition of the Photocurable Resin Composition**

| Constituent Compound | Example | | | | | | | | | Comparative Example | | |
|---|---|---|---|---|---|---|---|---|---|---|---|---|
| | 1 | 2 | 3 | 4 | 5 | 6 | 7 | 8 | 9 | 1 | 2 | 3 |
| Monomer I | 50 | 50 | 50 | 50 | - | - | - | - | 24 | 50 | - | 25 |
| Monomer II | 47 | 47 | 47 | 47 | - | - | - | - | 24 | 48 | - | 24 |
| Monomer III | - | - | - | - | 97 | 97 | 97 | 97 | 48 | - | 98 | 48 |
| Initiator I | 1 | 1 | 1 | 1 | - | - | - | - | 1 | 1 | - | 1 |
| Initiator II | - | - | - | - | 1 | 1 | 1 | 1 | 1 | - | 1 | 1 |
| Sensitizer I | 1 | 1 | 1 | 1 | - | - | - | - | 1 | 1 | - | 1 |
| Dye | | | | | | | | | | | | |
| Formula 6 | 1 | - | - | - | 1 | - | - | - | 1 | - | - | - |
| Formula 7 | - | 1 | - | - | - | 1 | - | - | - | - | - | - |
| Formula 8 | - | - | 1 | - | - | - | 1 | - | - | - | - | - |
| Formula 9 | - | - | - | 1 | - | - | - | 1 | - | - | - | - |

TABLE 2

Photocurable Resin Composition

Maximum Absorption Wavelength (λmax) and Cure Depth (mm)

| | | (λmax) | Cure depth (mm) |
|---|---|---|---|
| Example | 1 | 509 | < 0.1 |
| | 2 | 505 | 0.2 |
| | 3 | 490 | < 0.1 |
| | 4 | 483 | 0.1 |
| | 5 | 509 | 0.1 |
| | 6 | 505 | 0.15 |
| | 7 | 490 | < 0.1 |
| | 8 | 483 | 0.1 |
| | 9 | 509 | < 0.1 |
| Comparative Example | | | |
| | 1 | <300 | >10.0 |
| | 2 | <300 | >10.0 |
| | 3 | <300 | >10.0 |

## Claims

1. A method of generating three-dimensional objects comprising applying light of wavelength 450-550 nm by a stereolithographic technique to a photopolymerisable resin composition comprising:
   (a) a compound having at least one polymerisable unsaturated bond per molecule and a free radical photoinitiator, and/or
   (b) a compound capable of cationic polymerisation and a cationic photoinitiator,
   said photopolymerisable resin composition also containing a compound of which the wavelength of maximum absorption is in the range 400-600 nm.

2. A method according to claim 1 wherein the compound having a wavelength of maximum absorption in the range 400-600 nm is a dye of the xanthene, anthraquinone or azo series.

3. A method according to claim 1 or claim 2 wherein the photopolymerisable resin composition contains from 0.01 to 10% by weight of the compound having a wavelength of maximum absorption in the range 400-600 nm.

4. A method according to claim 3 wherein the photopolymerisable composition contains from 0.01 to 1% by weight of the compound having a wavelength of maximum absorption in the range 400-600 nm.

European Patent Office

# EUROPEAN SEARCH REPORT

Application Number

EP 92 30 8452

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 425 440 (CIBA-GEIGY AG)<br>* page 5, line 7 - line 8 *<br>* page 5, line 16 - line 28; claims 1,9,12 *<br>--- | 1-4 | G03C9/08<br>G03F7/031<br>G03F7/09 |
| A | EP-A-0 344 910 (MINNESOTA MINING AND MANUFACTURING COMPANY)<br>* page 8, line 27 - line 33 *<br>* page 14, line 15 - line 17 *<br>* page 14, line 52 *<br>----- | 1-4 | |
| | | | TECHNICAL FIELDS SEARCHED (Int. Cl.5 ) |
| | | | G03C<br>G03F<br>C08F |

The present search report has been drawn up for all claims

| Place of search | Date of completion of the search | Examiner |
|---|---|---|
| THE HAGUE | 16 DECEMBER 1992 | DUPART J-M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)